# EUROPÄISCHE PATENTANMELDUNG

(11) **EP 1 806 839 A1**
(43) Veröffentlichungstag der Anmeldung: **11.07.2007**
(21) Anmeldenummer: 06026382.9
(22) Anmeldetag: 20.12.2006
(51) Int. Cl.: H03F 1/42, H03F 3/45

(54) **Kaskoden-Differenzverstärker**

(30) Priorität: 28.12.2005 DE 102005062767
(71) Anmelder: ATMEL Germany GmbH, 74072 Heilbronn (DE)
(72) Erfinder: Bromberger, Christoph, 74074 Heilbronn (DE)
(74) Vertreter: Müller, Wolf-Christian

(57) **Zusammenfassung**

Kaskoden-Differenzverstärker
- mit jeweils zwei zu einer Kaskodeschaltung verschalteten Transistoren (Q) in jedem Zweig (1, 2) und
- mit einer Kreuzkompensation (Neutralisation) mit zumindest einem Paar von Kapazitäten zur Kompensation einer parasitären Kapazität eines Transistors (Q) jedes Zweiges (1, 2), wobei sich jeweils eine Kapazität des Paares mit der parasitären Kapazität des Transistors (Q) des zugehörigen Zweiges (1, 2) gleicht.

## Beschreibung

Die vorliegende Erfindung betrifft einen integrierten Kaskoden-Differenzverstärker.

Hochfrequenz-Verstärker werden für eine Vielzahl von Anwendungsfällen benötigt. So dienen Hochfrequenz-Verstärker der Verstärkung von empfangenen oder zu sendenden Radiosignalen. Weiterhin werden Hochfrequenz-Verstärker in Mobiltelefonen oder Radaranlagen verwendet. Für mehrere Anwendungen ist es dabei ausreichend, dass der Verstärker lediglich ein schmales Frequenzband im Bereich einer Betriebsfrequenz verstärkt. Ein derartiger Verstärker wird auch als Selektivverstärker bezeichnet. Bekannte Verstärkerschaltungen sind beispielsweise der Differenzverstärker oder ein Kaskode-Verstärker.

Eine Anordnung zweiter Transistoren als Kaskode-Verstärker bewirkt, dass ein Miller-Effekt, der bei Transistoren in Emitterschaltung auftritt, zu vernachlässigen ist, so dass der Frequenzgang des Kaskodeverstärkers unabhängig von der den Miller-Effekt beeinflussenden Basis-Kollektor-Kapazität des Transistors in Emitterschaltung ist.

Ein Kaskode-Differenzverstärker ist beispielsweise aus der EP 1 480 333 A2 bekannt. Zusätzlich ist eine Gegenkopplung offenbart, wobei ein erster Kondensator den Ausgang des ersten Zweiges des Differenzverstärkers mit dem Eingang des zweiten Zweiges des Differenzverstärkers rückkoppelt. Ein zweiter Kondensator ist für die Rückkopplung mit dem Ausgang des zweiten Zweiges und dem Eingang des ersten Zweiges des Differenzverstärkers verbunden. Mittels der Rückkopplung werden Instabilitäten des Differenzverstärkers durch eine Begrenzung des Frequenzganges reduziert.

Der Erfindung liegt die erste Aufgabe zu Grunde, einen Kaskoden-Differenzverstärker weiter zu entwickeln. Diese erste Aufgabe wird durch die Merkmale des Anspruchs 1 gelöst. Vorteilhafte Weiterbildungen der Erfindung sind Gegenstand von Unteransprüchen.

Zur Lösung dieser Aufgabe ist ein Kaskoden-Differenzverstärker mit jeweils zwei zu einer Kaskodeschaltung verschalteten Transistoren in jedem Zweig des Kaskoden-Differenzverstärkers vorgesehen. Weiterhin weist der Kaskoden-Differenzverstärker zumindest eine Kreuzkompensation mit zumindest einem Paar von Kapazitäten auf. In unterschiedlichen Lösungsvarianten kompensiert jede der Kapazitäten des Paares eine parasitäre Kapazität der Transistoren jeder Kaskodeschaltung.

In einer ersten Lösungsvariante dient das Paar von Kapazitäten zur Kompensation einer Basis-Emitter-Kapazität jedes Zweiges des Kaskoden-Differenzverstärkers. Jeweils eine Kapazität des Paares gleicht der Basis-Emitter-Kapazität des zugehörigen Zweiges des Kaskoden-Differenzverstärkers. Damit sich die jeweilige parasitäre Kapazität und die zugehörige Kapazität zur Kompensation gleicht weisen beide Kapazitäten eine im Rahmen des Fertigungsprozesses erzielbare Übereinstimmung der elektrischen Parameter - wie beispielsweise Kapazitätswert oder Abhängigkeit des Kapazitätswertes von einer Kapazitäts-Spannung - auf.

In einer zweiten Lösungsvariante dient das Paar von Kapazitäten zur Kompensation einer Basis-Kollektor-Kapazität jedes Zweiges des Kaskoden-Differenzverstärkers. Jeweils eine Kapazität des Paares gleicht der Basis-Kollektor-Kapazität des zugehörigen Zweiges des Kaskoden-Differenzverstärkers. Damit sich die jeweilige parasitäre Kapazität und die zugehörige Kapazität zur Kompensation gleicht weisen beide Kapazitäten eine im Rahmen des Fertigungsprozesses erzielbare Übereinstimmung der elektrischen Parameter - wie beispielsweise Kapazitätswert oder Abhängigkeit des Kapazitätswertes von einer Kapazitäts-Spannung - auf.

In einer dritten Lösungsvariante dient das Paar von Kapazitäten zur Kompensation einer Gate-Source-Kapazität jedes Zweiges des Kaskoden-Differenzverstärkers. Jeweils eine Kapazität des Paares gleicht der Gate-Source-Kapazität des zugehörigen Zweiges des Kaskoden-Differenzverstärkers. Damit sich die jeweilige parasitäre Kapazität und die zugehörige Kapazität zur Kompensation gleicht weisen beide Kapazitäten eine im Rahmen des Fertigungsprozesses erzielbare Übereinstimmung der elektrischen Parameter - wie beispielsweise Kapazitätswert oder Abhängigkeit des Kapazitätswertes von einer Kapazitäts-Spannung - auf.

In einer vierten Lösungsvariante dient das Paar von Kapazitäten zur Kompensation einer Gate-Drain-Kapazität jedes Zweiges des Kaskoden-Differenzverstärkers. Jeweils eine Kapazität des Paares gleicht der Gate-Drain-Kapazität des zugehörigen Zweiges des Kaskoden-Differenzverstärkers. Damit sich die jeweilige parasitäre Kapazität und die zugehörige Kapazität zur Kompensation gleicht weisen beide Kapazitäten eine im Rahmen des Fertigungsprozesses erzielbare Übereinstimmung der elektrischen Parameter - wie beispielsweise Kapazitätswert oder Abhängigkeit des Kapazitätswertes von einer Kapazitäts-Spannung - auf.

Die vier Lösungsvarianten können selbstverständlich auch miteinander kombiniert werden um beispielsweise unterschiedliche parasitäre Kapazitäten der Transistoren zu kompensieren. Im Gegensatz zur Gegenkopplung, die das Signal vom Ausgang auf den Eingang des Kaskoden-Differenzverstärkers rückkoppelt, bewirkt die Kreuzkompensation - die auch als Neutralisation bezeichnet wird -, dass die wirkende parasitäre Kapazität des Transistors kompensiert wird, indem sich rechnerisch zu einem Kapazitätswert der negative Kapazitätswert hinzuaddiert.

Weiterhin wird die Aufgabe durch einen Kaskoden-Differenzverstärker mit einer entsprechenden Schaltung gelöst. Dieser weist zumindest einen ersten Transistor, einen zweiten Transistor, einen dritten Transistor und einen vierten Transistor auf. Zusätzlich kann der Kaskoden-Differenzverstärker beispielsweise noch Bauelemente zur Arbeitspunkteinstellung der Transistoren und/oder aktive oder passive Impedanzen aufweisen.

Der erste Transistor weist eine erste Basis, einen ersten Kollektor und einen ersten Emitter auf, wobei die erste Basis des ersten Transistors mit einem ersten Eingang des Kaskoden-Differenzverstärkers verbunden ist. Der zweite Transistor weist eine zweite Basis, einen zweiten Kollektor und einen zweiten Emitter auf, wobei die zweite Basis des zweiten Transistors mit einem zweiten Eingang des Kaskoden-Differenzverstärkers verbunden ist. Vorzugsweise sind der erste Transistor und der zweite Transistor im Rahmen von Fertigungstoleranzen gleich ausgebildet.

Der dritte Transistor weist eine dritte Basis, einen dritten Kollektor und einen dritten Emitter auf. Dabei ist der Emitter des dritten Transistors mit dem Kollektor des ersten Transistors verbunden. Der vierte Transistor weist eine vierte Basis, einen vierten Kollektor und einen vierten Emitter auf. Dabei ist der vierte Emitter des vierten Transistors mit dem zweiten Kollektor des zweiten Transistors verbunden. Vorzugsweise sind der dritte Transistor und der vierte Transistor im Rahmen der Fertigungstoleranzen gleich ausgebildet.

Es sind mehrere Erfindungsvarianten vorgesehen, die jeweils einer parasitären Kapazität der Transistoren zugeordnet sind. In einer ersten Variante weist der Kaskoden-Differenzverstärker ein erstes Paar von insbesondere symmetrisch angeordneten Kapazitäten auf. Dabei ist eine erste Kapazität des ersten Paares von Kapazitäten mit der dritten Basis des dritten Transistors und mit dem vierten Emitter des vierten Transistors verbunden. Der Wert der ersten Kapazität des ersten Paares entspricht vorzugsweise der Basis-Emitter-Kapazität des dritten Transistors und ist vorteilhafterweise durch eine Basis-Emitter-Kapazität eines weiteren Transistors gebildet. Eine zweite Kapazität des ersten Paares ist mit der vierten Basis des vierten Transistors und mit dem dritten Emitter des dritten Transistors verbunden. Der Wert der zweiten Kapazität des ersten Paares entspricht vorzugsweise der Basis-Emitter-Kapazität des vierten Transistors und ist vorteilhafterweise durch eine Basis-Emitter-Kapazität eines weiteren Transistors gebildet.

In einer zweiten Variante weist der Kaskoden-Differenzverstärker ein zweites Paar von insbesondere symmetrisch angeordneten Kapazitäten auf. Dabei ist eine erste Kapazität des zweiten Paares von Kapazitäten mit der dritten Basis des dritten Transistors und mit dem vierten Kollektor des vierten Transistors verbunden. Der Wert der ersten Kapazität des zweiten Paares von Kapazitäten entspricht vorzugsweise der Basis-Kollektor-Kapazität des dritten Transistors und ist vorteilhafterweise durch eine Basis-Kollektor-Kapazität eines weiteren Transistors gebildet. Eine zweite Kapazität des zweiten Paares ist mit der vierten Basis des vierten Transistors und mit dem dritten Kollektor des dritten Transistors verbunden. Der Wert dieser zweiten Kapazität des zweiten Paares entspricht vorzugsweise der Basis-Kollektor-Kapazität des vierten Transistors und ist vorteilhafterweise durch eine Basis-Kollektor-Kapazität eines weiteren Transistors gebildet.

In einer dritten Variante weist der Kaskoden-Differenzverstärker ein drittes Paar von insbesondere symmetrisch angeordneten Kapazitäten auf. Dabei ist eine erste Kapazität des dritten Paares von Kapazitäten mit der ersten Basis des ersten Transistors und mit dem zweiten Emitter des zweiten Transistors verbunden. Der Wert der ersten Kapazität des dritten Paares von Kapazitäten entspricht vorzugsweise der Basis-Emitter-Kapazität des ersten Transistors und ist vorteilhafterweise durch eine Basis-Emitter-Kapazität eines weiteren Transistors gebildet. Eine zweite Kapazität des dritten Paares ist mit der zweiten Basis des zweiten Transistors und mit dem ersten Emitter des ersten Transistors verbunden. Der Wert der zweiten Kapazität des dritten Paares entspricht vorzugsweise der Basis-Emitter-Kapazität des zweiten Transistors und ist vorteilhafterweise durch eine Basis-Emitter-Kapazität eines weiteren Transistors gebildet.

In einer vierten Variante weist der Kaskoden-Differenzverstärker ein viertes Paar von insbesondere symmetrisch angeordneten Kapazitäten auf. Dabei ist eine erste Kapazität des vierten Paares von Kapazitäten mit der ersten Basis des ersten Transistors und mit dem zweiten Kollektor des zweiten Transistors verbunden. Der Wert der ersten Kapazität des vierten Paares entspricht vorzugsweise der Basis-Kollektor-Kapazität des ersten Transistors und ist vorteilhafterweise durch eine Basis-Kollektor-Kapazität eines weiteren Transistors gebildet. Die zweite Kapazität des vierten Paares ist mit der zweiten Basis des zweiten Transistors und mit dem ersten Kollektor des ersten Transistors verbunden. Der Wert der zweiten Kapazität des vierten Paares entspricht vorzugsweise der Basis-Kollektor-Kapazität des zweiten Transistors und ist vorteilhafterweise durch eine Basis-Kollektor-Kapazität eines weiteren Transistors gebildet.

Jede Variante für sich kann je nach der äußeren Beschaltung, also beispielsweise einer Quellimpedanz, welche Quellimpedanz der Kaskoden-Differenzverstärker unter Anderem aufgrund einer vorgeschalteten Stufe, einer Anpassschaltung oder einer mit dem Eingang des Kaskoden-Differenzverstärkers verbundenen Empfangsantenne erfahren kann, oder einer Lastimpedanz, welche Lastimpedanz der Kaskoden-Differenzverstärker insbesondere aufgrund einer über eine Anpassschaltung mit seinem Ausgang verbundene Sende-Antenne erfahren kann, einzeln vorteilhaft sein.

Eine besonders vorteilhafte Weiterbildung der Erfindung sieht vor, dass der Kaskoden-Differenzverstärker zumindest zwei Paare von Kapazitäten aus dem ersten Paar, dem zweiten Paar, dem dritten Paar oder dem vierten Paar aufweist. Dabei kann der Differenzverstärker zumindest zwei, aber auch drei oder vier der genannten Paare von Kapazitäten aufweisen. Durch die entsprechenden Kombinationen der vier Varianten ist der Kaskoden-Differenzverstärker in weiteren elf Untervarianten, sechs Untervarianten mit zwei Paaren von Kapazitäten, vier Untervarianten mit drei Paaren von Kapazitäten oder eine Untervariante mit vier Paaren von Kapazitäten ausführbar. Beispielsweise in Abhängigkeit von einer äußeren Beschaltung und/oder einer Ausbildung der einzelnen Transistoren kann eine bestimmte Untervariante besonders vorteilhaft sein.

In einer bevorzugten Weiterbildung ist der Kaskoden-Differenzverstärker symmetrisch ausgebildet. Zur symmetrischen Ausbildung sind vorzugsweise beide Äste des Kaskoden-Differenzverstärkers im Rahmen der Fertigungstoleranzen einander spiegelgleich.

In einer vorteilhaften Ausgestaltung ist vorgesehen, dass das vierte Paar von Kapazitäten durch eine Basis-Kollektor-Kapazität eines fünften Transistors und durch eine Basis-Kollektor-Kapazität eines sechsten Transistors gebildet ist. Der Kaskoden-Differenzverstärker weist hierbei den fünften Transistor mit einer fünften Basis, einem fünften Kollektor und einem fünften Emitter auf, wobei die fünfte Basis des fünften Transistors mit der ersten Basis des ersten Transistors verbunden ist. Zudem ist der fünfte Kollektor des fünften Transistors mit dem zweiten Kollektor des zweiten Transistors verbunden. Der Kaskoden-Differenzverstärker weist weiterhin den sechsten Transistor mit einer sechsten Basis, einem sechsten Kollektor und einem sechsten Emitter auf. Dabei ist die sechste Basis des sechsten Transistors mit der zweiten Basis des zweiten Transistors verbunden. Zudem ist der sechste Kollektor des sechsten Transistors mit dem ersten Kollektor des ersten Transistors verbunden. Vorzugsweise sind der fünfte Emitter des fünften Transistors und der sechste Emitter des sechsten Transistors gleichstrommäßig gegeneinander isoliert. Weiterhin vorzugsweise sind der fünfte Emitter des fünften Transistors und der sechste Emitter des sechsten Transistors gegen den Rest der Schaltung isoliert.

Diese Ausgestaltung weiterbildend bildet der sechste Kollektor des sechsten Transistors mit dem ersten Kollektor des ersten Transistors und/oder mit dem dritten Emitter des dritten Transistors ein durchgehendes erstes Halbleitergebiet. Dieses Halbleitergebiet ist daher nicht durch metallische Gebiete unterbrochen, sondern einstückig aus einem Halbleitermaterial, beispielsweise Silizium, gebildet. Diese Ausgestaltung weiterhin weiterbildend bildet der fünfte Kollektor des fünften Transistors mit dem zweiten Kollektor des zweiten Transistors und/oder mit dem vierten Emitter des vierten Transistors ein durchgehendes zweites Halbleitergebiet. Das erste und das zweite Halbleitergebiet sind vorzugsweise im Rahmen der Fertigungstoleranzen gleich ausgebildet.

In einer anderen, auch kombinierbaren Ausgestaltung ist vorteilhafterweise vorgesehen, dass das dritte Paar von Kapazitäten durch eine Basis-Emitter-Kapazität eines siebten Transistors und durch eine Basis-Emitter-Kapazität eines achten Transistors gebildet ist. Der Kaskoden-Differenzverstärker weist hierbei den siebten Transistor mit einer siebten Basis, einem siebten Kollektor und einem siebten Emitter auf. Dabei ist die siebte Basis des siebten Transistors mit der ersten Basis des ersten Transistors verbunden. Zudem ist der siebte Emitter des siebten Transistors mit dem zweiten Emitter des zweiten Transistors verbunden. Der Kaskoden-Differenzverstärker weist hierbei zudem den achten Transistor mit einer achten Basis, einem achten Kollektor und einem achten Emitter auf. Dabei ist die achte Basis des achten Transistors mit der zweiten Basis des zweiten Transistors verbunden. Zudem ist der achte Emitter des achten Transistors mit dem ersten Emitter des ersten Transistors verbunden. Vorzugsweise sind der siebte Kollektor des siebten Transistors und der achte Kollektor des achten Transistors gleichstrommäßig gegeneinander isoliert. Weiterhin vorzugsweise sind der der siebte Kollektor des siebten Transistors und der achte Kollektor des achten Transistors gegen den Rest der Schaltung isoliert.

In einer anderen, auch kombinierbaren Ausgestaltung ist vorteilhafterweise vorgesehen, dass das zweite Paar von Kapazitäten durch eine Basis-Kollektor-Kapazität eines neunten Transistors und durch eine Basis-Kollektor-Kapazität eines zehnten Transistor gebildet ist. Der Kaskoden-Differenzverstärker weist hierbei den neunten Transistor mit einer neunten Basis, einem neunten Kollektor und einem neunten Emitter auf. Zudem weist der Kaskoden-Differenzverstärker den zehnten Transistor mit einer zehnten Basis, einem zehnten Kollektor und einem zehnten Emitter auf. Dabei ist die neunte Basis des neunten Transistors mit der dritten Basis des dritten Transistors verbunden. Weiterhin ist der neunte Kollektor des neunten Transistors mit dem vierten Kollektor des vierten Transistors verbunden. Weiterhin ist die zehnte Basis des zehnten Transistors mit der vierten Basis des vierten Transistors verbunden. Zudem ist der zehnte Kollektor des zehnten Transistors mit dem dritten Kollektor des dritten Transistors verbunden. Vorzugsweise sind der neunte Emitter des neunten Transistors und der zehnte Emitter des zehnten Transistors gleichstrommäßig gegeneinander isoliert. Weiterhin vorzugsweise sind der der neunte Emitter des neunten Transistors und der zehnte Emitter des zehnten Transistors gegen den Rest der Schaltung isoliert.

In einer wiederum anderen, auch kombinierbaren Ausgestaltung ist vorteilhafterweise vorgesehen, dass das erste Paar von Kapazitäten durch eine Basis-Emitter-Kapazität eines elften Transistors und durch eine Basis-Emitter-Kapazität eines zwölften Transistors gebildet ist. Der Kaskoden-Differenzverstärker weist hierbei den elften Transistor mit einer elften Basis, einem elften Kollektor und einem elften Emitter auf. Zudem weist der Kaskoden-Differenzverstärker den zwölften Transistor mit einer zwölften Basis, einem zwölften Kollektor und einem zwölften Emitter auf. Dabei ist die elfte Basis des elften Transistors mit der dritten Basis des dritten Transistors verbunden. Der elfte Emitter des elften Transistors ist mit dem vierten Emitter des vierten Transistors verbunden. Weiterhin ist die zwölfte Basis des zwölften Transistors mit der vierten Basis des vierten Transistors verbunden. Zudem ist der zwölfte Emitter des zwölften Transistors mit dem dritten Emitter des dritten Transistors verbunden. Vorzugsweise sind der elfte Kollektor des elften Transistors und der zwölfte Kollektor des zwölften Transistors gleichstrommäßig gegeneinander isoliert. Weiterhin vorzugsweise sind der der elfte Kollektor des elften Transistors und der zwölfte Kollektor des zwölften Transistors gegen den Rest der Schaltung isoliert.

Bevorzugt ist der Kaskoden-Differenzverstärker zur Verstärkung eines Hochfrequenzsignals ausgebildet. Unter Hochfrequenz ist dabei ein Frequenzbereich zu verstehen, in dem das transiente Verhalten eines einzelnen Transistors wesentlich durch parasitäre Kapazitäten des Transistors und insbesondere durch den Miller-Effekt beeinflusst wird.

In einer vorteilhaften Weiterbildung der Erfindung ist zumindest ein Anpassnetzwerk zur Ausbildung eines Selektiwerstärkers, insbesondere eines Bandpasses vorgesehen, das mit zumindest einem Transistor verbunden ist. Ein derartiges Anpassnetzwerk kann aus mehreren aktiven und/oder passiven Bauelementen, wie integrierte Kapazitäten, Induktivitäten oder Dioden gebildet sein.

Vorteilhafterweise ist zumindest ein Transistor ein Hetero-Bipolartransistor. Zur Ausbildung eines derartigen Bipolartransistors mit einem Hetero-PN-Übergang ist vorteilhafterweise ein Silizium-Germanium-Mischkristall ausgebildet.

Vorzugsweise ist der Kaskoden-Differenzverstärker auf einem Halbleiterchip integriert. Die Erfindung ausgestaltend bildet der sechste Kollektor des sechsten Transistors mit dem ersten Kollektor des ersten Transistors und/oder mit dem dritten Emitter des dritten Transistors ein durchgehendes erstes Halbleitergebiet, das daher nicht durch metallische Verbindungen unterteilt ist. Dieses Halbleitergebiet besteht vorteilhafterweise aus monokristallinem Silizium, das ausschließlich mit Dotanden eines Leitungstyps, beispielsweise eines n-Leitungstyps, dotiert ist. Besonders bevorzugt ist zudem vorgesehen, dass der fünfte Kollektor des fünften Transistors mit dem zweiten Kollektor des zweiten Transistors und/oder mit dem vierten Emitter des vierten Transistors ein durchgehendes zweites Halbleitergebiet, insbesondere aus mit demselben Leitungstyp dotiertem monokristallinem Silizium, bildet.

In einer Weiterbildung der Erfindung ist vorgesehen, dass der Kaskoden-Differenzverstärker zumindest teilweise anstelle von Bipolartransistoren Feldeffekttransistoren aufweist, wobei die Feldeffekttransistoren mit jeweils einem Tor (Gate) anstelle einer Basis, einer Senke (Drain) anstelle eines Kollektors und einer Quelle (Source) anstelle eines Emitters verbunden sind. Ebenfalls ist es vorteilhaft, in einer Schaltung mit unterschiedlichen Transistortypen sowohl einen oder mehrere Bipolartransistoren als auch einen oder mehrere Feldeffekttransistoren innerhalb des Kaskoden-Differenzverstärkers zu verbinden.

Ebenfalls ist es möglich bei einem Differenzverstärker verschiedene parasitäre Kapazitäten durch eine mehrfache Kreuzkompensation zu neutralisieren. Dabei weist der Differenzverstärker einen ersten Transistor, einen zweiten Transistor, einen dritten Transistor und einen vierten Transistor auf. Der erste Transistor weist eine erste Basis, einen ersten Kollektor und einen ersten Emitter auf, wobei der erste Transistor mit einem ersten Eingang verbunden ist. Der zweite Transistor weist eine zweite Basis, einen zweiten Kollektor und einem zweiten Emitter auf, wobei der zweite Transistor mit einem zweiten Eingang verbunden ist. Der erste Transistor und der zweite Transistor sind in drei unterschiedlichen Erfindungsvarianten in Emitterschaltung oder Basisschaltung oder Kollektorschaltung angeschlossen. Der dritte Transistor weist eine dritte Basis, einem dritte Kollektor und einen dritten Emitter auf, wobei die dritte Basis des dritten Transistors mit der ersten Basis des ersten Transistors und der dritte Emitter des dritten Transistors mit dem ersten Emitter des ersten Transistors verbunden sind. Der vierte Transistor weist eine vierte Basis, einen vierten Kollektor und einen vierten Emitter, wobei die vierte Basis des vierten Transistors mit der zweiten Basis des zweiten Transistors und der vierte Emitter des vierten Transistors mit dem zweiten Emitter des zweiten Transistors verbunden sind.

Es ist möglich, dass der erste Transistor und der zweite Transistor im Rahmen der Fertigungstoleranzen gleich ausgebildet sind. Ebenfalls können der dritte Transistor und der vierte Transistor im Rahmen der Fertigungstoleranzen gleich ausgebildet sein. Der erste Transistor und/oder der zweite Transistor und/oder der dritte Transistor und/oder der vierte Transistor können auf einem Halbleiterchip zueinander benachbart angeordnet sein.

Der Differenzverstärker kann einen fünften Transistor und einen sechsten Transistor aufweisen. Der fünfte Transistor weist eine fünfte Basis, einen fünften Kollektor und einen fünften Emitter auf. Der sechste Transistor weist eine sechste Basis, einen sechsten Kollektor und einen sechsten Emitter auf. Die fünfte Basis des fünften Transistors ist mit der ersten Basis des ersten Transistors und der fünfte Kollektor des fünften Transistors ist mit dem zweiten Kollektor des zweiten Transistors verbunden. Die sechste Basis des sechsten Transistors ist mit der zweiten Basis des zweiten Transistors und der sechste Kollektor des sechsten Transistors ist mit dem ersten Kollektor des ersten Transistors verbunden. Alle Transistoren können auf einem Halbleiterplättchen integriert sein. Zumindest der erste Transistor und der fünfte Transistor und/oder der zweite Transistor und der sechste Transistor können eine im Rahmen der Fertigungstoleranzen gleiche Kollektor-Basis-Kapazität aufweisen.

Im Folgenden wird die Erfindung in Ausführungsbeispielen anhand von Zeichnungen näher erläutert.

Dabei zeigen
- Fig. 1: eine erste Ausführungsform eines Schaltkreises eines Kaskoden-Differenzverstärkers mit npn-Bipolartransistoren,
- Fig. 2: eine zweite Ausführungsform eines Schaltkreises eines Kaskoden-Differenzverstärkers mit pnp-Bipolartransistoren,
- Fig. 3: eine dritte Ausführungsform eines Schaltkreises eines Kaskoden-Differenzverstärkers mit npn-Bipolartransistoren, und
- Fig. 4: eine vierte Ausführungsform eines Schaltkreises eines Kaskoden-Differenzverstärkers mit npn-Bipolartransistoren.

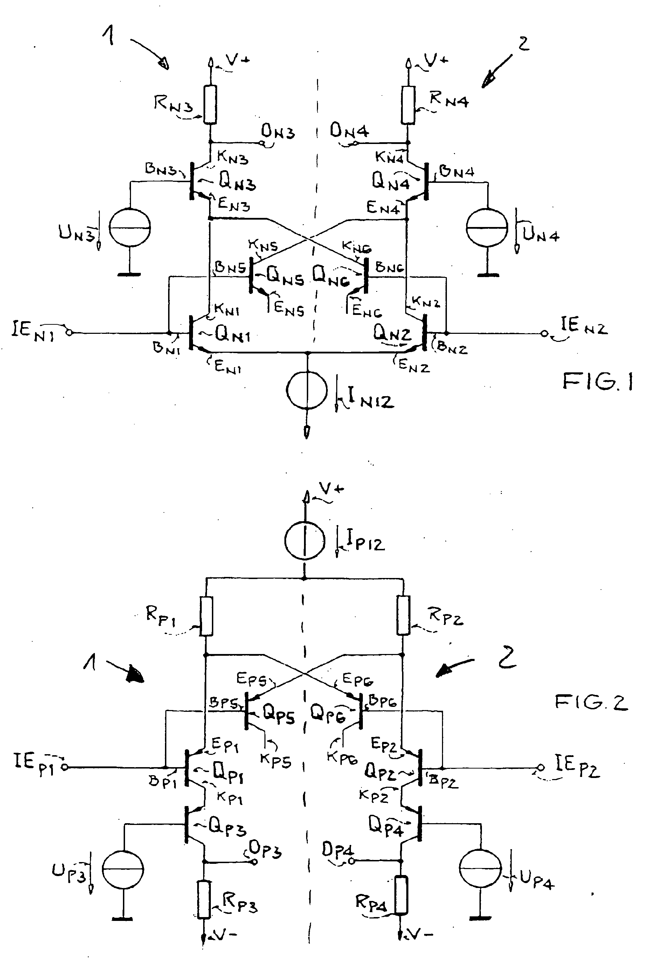

In den Figuren 1 bis 4 sind vier verschiedene Varianten von Verstärkerschaltungen dargestellt. Neben den in den Figuren 1 bis 4 dargestellten Bauelementen können weitere passive und/oder aktive Bauelemente beispielsweise zur Signalentkopplung oder zur Arbeitspunkteinstellung auf einem Halbleiterchip integriert sein. Diese sind in den Figuren 1 bis 4 zu Gunsten einer einfacheren Darstellung fortgelassen.

Ein Vorteil einer Kaskodenschaltung liegt in der Kompensation des Miller-Effektes. Durch einen hohen Ausgangsspannungshub erscheint die Basis-Kollektor-Kapazität eines in Emitterschaltung betriebenen Transistors im Ersatzschaltbild zwischen Eingang und Masse wirkend mit der Stromverstärkung multipliziert. Wird als Last eines stromverstärkenden Transistors in Emitterschaltung ein impedanzwandelnder Transistor in Basisschaltung gewählt, so erfährt der Kollektor des Transistors in Emitterschaltung einen Ausgangsspannungshub, welcher vom kleinen Eingangswiderstand der impedanzwandelnden Stufe (Basisschaltung) und nicht mehr von einem höheren Lastwiderstand bestimmt wird. Der Miller-Effekt, der die Basis-Kollektor-Kapazität des in Emitterschaltung betriebenen Transistors mit dem Verstärkungsfaktor vergrößert, ist durch die Verwendung der Kaskodenschaltung im Wesentlichen aufgehoben. Gleiches gilt auch für zwei Kaskoden, die in jedem Ast eines Differenzverstärkers verschaltet werden.

Ein alternativer Weg, die Miller-Kapazität zu reduzieren, bietet eine Kompensation der Basis-Kollektor-Kapazität durch Kreuzkompensation, die auch als Neutralisation bezeichnet wird (Alan Grebene, Bipolar and MOS Analog Integrated Circuit Design", John Wiley, 1984, p. 415f). Dabei erfährt eine Kapazität zwischen der Basis im ersten Ast des Differenzverstärkers und dem Kollektor im zweiten Ast des Differenzverstärkers einen Spannungshub, der entgegengesetzt und betragsmäßig gleich dem Spannungshub an der Basis-Kollektor-Kapazität im ersten Ast des Differenzverstärkers ist, sofern die Kapazitäten sich gleichen. Hierdurch wird effektiv zu der Basis-Kollektor-Kapazität eine zweite Kapazität mit einem Miller-Faktor von -1 parallel geschaltet, und hierdurch die Basis-Kollektor-Kapazität kompensiert. Da die parallel geschaltete Kapazität dem beispielsweise spannungsabhängigen Verlauf der Basis-Kollektor-Kapazität folgen sollte, verwendet man die Basis-Kollektor-Kapazität eines Dummy-Transistors auf demselben Halbleiterplättchen zur Kompensation.

In Fig. 1 ist ein Schaltkreis eines Kaskoden-Differenzverstärkers mit sechs npn-Bipolartransistoren Q_{N1} bis Q_{N6} dargestellt. Der Kaskoden-Differenzverstärker weist zwei symmetrische Zweige 1 und 2 auf. Die Symmetrieachse der beiden Zweige ist gestrichelt dargestellt. Die Eingänge IE_{N1} und IE_{N2} sind mit den Basen B_{N1} und B_{N2} des ersten npn-Bipolartransistors Q_{N1} und des zweiten npn-Bipolartransistors Q_{N2} verbunden. Der erste und zweite Transistor Q_{N1} und Q_{N2} sind dabei in Emitterschaltung betrieben. Die Transistoren Q_{N3} und Q_{N4} sind in Basisschaltung betrieben. Hierzu ist die jeweilige Basis B_{N3} und B_{N4} mit je einer Spannungsquelle U_{N3} und U_{N4} verbunden, die bezüglich der Betriebsfrequenz als Kurzschluss nach Masse wirken. Der erste Transistor Q_{N1} bildet zusammen mit dem dritten Transistor Q_{N3} eine erste Kaskode. Der zweite Transistor Q_{N2} bildet zusammen mit dem vierten Transistor Q_{N4} eine zweite Kaskode. Durch die Verwendung der zwei Kaskoden weisen sowohl der in Emitterschaltung betriebene erste Transistor Q_{N1} als auch der in Emitterschaltung betriebene zweite Transistor Q_{N2} keinen signifikanten Miller-Effekt bezüglich deren Basis-Kollektor-Kapazität auf.

Obwohl durch die beiden Kaskoden kein signifikanter Miller-Effekt mehr auftritt, sind in dem Schaltkreis der Fig. 1 der fünfte Transistor Q_{N5} und der sechste Transistor Q_{N6} vorgesehen. Der fünfte Transistor Q_{N5} und der sechste Transistor Q_{N6} sind analog einer Kreuzkompensation verschaltet, indem die fünfte Basis B_{N5} des fünften Transistors Q_{N5} mit der ersten Basis B_{N1} des ersten Transistors Q_{N1} und der fünfte Kollektor K_{N5} des fünften Transistors Q_{N5} mit dem zweiten Kollektor K_{N2} des zweiten Transistors Q_{N2} verbunden sind, und indem die sechste Basis B_{N6} des sechsten Transistors Q_{N6} mit der zweiten Basis B_{N2} des zweiten Transistors Q_{N2} und der sechste Kollektor K_{N6} des sechsten Transistors Q_{N6} mit dem ersten Kollektor K_{N1} des ersten Transistors Q_{N1} verbunden sind. Der fünfte und sechste Emitter E_{N5} und E_{N6} sind dabei nicht verbunden.

Hinsichtlich des Miller-Effektes erfüllt die Kreuzkompensation keinen Zweck, da bereits die zwei Kaskoden den Miller-Effekt unterbinden. Während sich auch tatsächlich Leistungsverstärkung und Frequenzverhalten eines Kaskode-Differenzverstärkers durch diese Kreuz-Gegenkopplung nicht wesentlich ändern, weist die Schaltung der Fig. 1 den für den Fachmann überraschenden Vorteil auf, dass sich eine unbedingte Stabilität des Kaskode-Differenzverstärkers über einen wesentlich weiteren Betriebsbereich, insbesondere über einen wesentlichen weiteren Bereich der Versorgungsspannung (V+ zu V-) auch ohne resistive Rückkopplung und mithin ohne Verlust an Verstärkung sicherstellen lässt. Zugleich ermöglichen die zwei Kaskoden einen großen Ausgangsspannungshubbereich gegenüber Einzeltransistoren in Emitterschaltung.

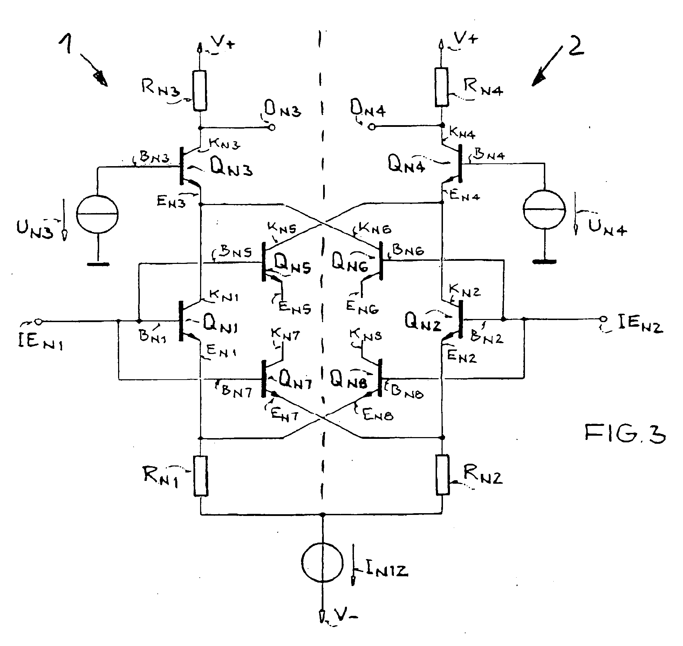

In Fig. 3 ist der Schaltkreis des Kaskoden-Differenzverstärkers aus Fig. 1 durch einen siebten Transistor Q_{N7} und einen achten Transistors Q_{N8} ergänzt. Dabei sind ein siebter Emitter E_{N7} des siebten Transistors Q_{N7} mit dem zweiten Emitter E_{N2} des zweiten Transistors Q_{N2} und ein achter Emitter E_{N8} des achten Transistors Q_{N8} ist mit dem ersten Emitter E_{N1} des ersten Transistors Q_{N1} verbunden. Weiterhin sind eine siebte Basis B_{N7} des siebten Transistors Q_{N7} mit der ersten Basis B_{N1} des ersten Transistors Q_{N1} und eine achte Basis B_{N8} des achten Transistors Q_{N8} ist mit der zweiten Basis B_{N2} des zweiten Transistors Q_{N2} verbunden. Der Kaskoden-Differenzverstärker weist zwei symmetrische Zweige 1 und 2 auf. Die Symmetrieachse der beiden Zweige ist gestrichelt dargestellt.

Analog der Kreuzgegenkopplung durch den fünften und den sechsten Transistor Q_{N5} und Q_{N6} kompensiert der siebte Transistor Q_{N7} die Basis-Emitter-Kapazität des ersten Transistors Q_{N1} und der achte Transistor Q_{N8} kompensiert die Basis-Emitter-Kapazität des zweiten Transistors Q_{N2}, wodurch die Stabilitäts- und Verstärkungseigenschaften der Schaltung weiter verbessert werden.

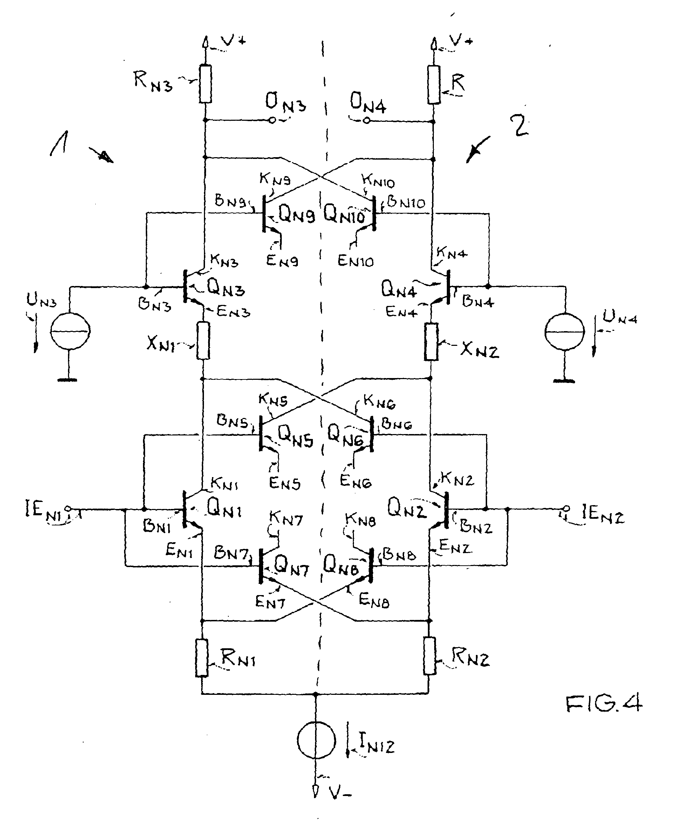

Im Schaltkreis der Fig. 4 ist der Schaltkreis der Fig. 3 um einen neunten Transistor Q_{N9} und einen zehnten Transistor Q_{N10} ergänzt. Der neunte Transistor Q_{N9} kompensiert die Basis-Kollektor-Kapazität des dritten Transistors Q_{N3}. Der zehnte Transistor Q_{N10} kompensiert die Basis-Kollektor-Kapazität des vierten Transistors Q_{N4}. Dabei sind ein neunter Kollektor K_{N9} des neunten Transistors Q_{N9} mit dem vierten Kollektor K_{N4} des vierten Transistors Q_{N4} und ein zehnter Kollektor K_{N10} des zehnten Transistors Q_{N10} ist mit dem dritten Kollektor K_{N3} des dritten Transistors Q_{N3} verbunden. Weiterhin sind eine neunte Basis B_{N9} des neunten Transistors Q_{N9} mit der dritten Basis B_{N3} des dritten Transistors Q_{N3} und eine zehnte Basis B_{N10} des zehnten Transistors Q_{N10} ist mit der vierten Basis B_{N4} des vierten Transistors Q_{N4} verbunden. Der neunte und zehnte Emitter E_{N9} und E_{N10} sind dabei nicht verbunden. Der Kaskoden-Differenzverstärker weist zwei symmetrische Zweige 1 und 2 auf. Die Symmetrieachse der beiden Zweige ist gestrichelt dargestellt.

Weiterhin zeigt Fig. 4 zwei Anpassnetzwerke X_{N1} und X_{N2}, die auf die Betriebsfrequenz des Verstärkers abgestimmt sind. Derartige Anpassnetzwerke weisen vorteilhafterweise passive Bauelemente, wie Kapazitäten und Induktivitäten, die beispielsweise zur Ausbildung eines Selektivverstärkers oder eines Breitbandverstärkers mit dem ersten Transistor Q_{N1} und/oder dem zweiten Transistor Q_{N2} verbunden sind, auf. Durch zwei weitere, in Fig. 4 nicht dargestellte Transistoren könnte zudem die Basis-Emitter-Kapazität des dritten Transistors Q_{N3} als auch die Basis-Emitter-Kapazität des vierten Transistors Q_{N4} kompensiert werden.

Vorzugsweise sind die Arbeitspunkte der zehn Transistoren Q_{N1} bis Q_{N10} und der Spannungshub des Kaskoden-Differenzverstärkers für eine Betriebsfrequenz derart ausgebildet, dass entlang einer Lastlinie im Ausgangskennlinienfeld ein unbedingt stabiler Bereich ausgebildet ist.

In Fig. 2 ist ein anderes Ausführungsbeispiel eines Kaskoden-Differenzverstärkers mit sechs pnp-Bipolartransistoren Q_{P1} bis Q_{P6} gezeigt. Der Kaskoden-Differenzverstärker weist zwei symmetrische Zweige 1 und 2 auf. Die Symmetrieachse der beiden Zweige ist gestrichelt dargestellt. Der erste Transistor Q_{P1} in Emitterschaltung zusammen mit dem dritten Transistor Q_{P3} in Basisschaltung und der zweite Transistor Q_{P2} in Emitterschaltung zusammen mit dem vierten Transistor Q_{P4} in Basisschaltung sind jeweils als Kaskode geschaltet. Der fünfte Transistor Q_{P5} ist zur Kompensation der Basis-Emitter-Kapazität des ersten Transistors Q_{P1} und der sechste Transistor Q_{P6} ist zur Kompensation des zweiten Transistors Q_{P2} verschaltet.

### Bezugszeichenliste

- V+: positiver Versorgungsspannungsanschluss
- V-: negativer Versorgungsspannungsanschluss
- I_{N12}, I_{P12}: Stromquelle
- U_{N1}, U_{N2}, U_{N3}, U_{N4}, U_{P3}, UP4: Spannungsquelle
- R_{N1}, R_{N2}, R_{N3}, R_{N4}, R_{P1}, R_{P2}, R_{P3}, R_{P4}: Widerstand
- IE_{N1}, IE_{P1}: erster Eingang
- IE_{N2}, IE_{P2}: zweiter Eingang
- O_{N3}, O_{P3}: erster Ausgang
- O_{N4}, O_{P4}: zweiter Ausgang
- Q_{N1} .Q_{N10}: npn-Bipolartransistor
- Q_{P1} .Q_{P6}: pnp-Bipolartransistor
- X_{N1}, X_{N2}: Anpassungsnetzwerk
- 1, 2: Zweige des Differenzverstärkers

## Patentansprüche

1. Kaskoden-Differenzverstärker
- mit jeweils zwei zu einer Kaskodeschaltung verschalteten Transistoren (Q) in jedem Zweig (1, 2) und
- mit einer Kreuzkompensation (Neutralisation) mit zumindest einem Paar von Kapazitäten
zur Kompensation einer Basis-Emitter-Kapazität jedes Zweiges (1, 2),
wobei sich jeweils eine Kapazität des Paares mit der Basis-Emitter-Kapazität des zugehörigen Zweiges (1, 2) gleicht,
und/oder
zur Kompensation einer Basis-Kollektor-Kapazität jedes Zweiges (1, 2), wobei sich jeweils eine Kapazität des Paares mit der Basis-Kollektor-Kapazität des zugehörigen Zweiges (1, 2) gleicht,
und/oder
zur Kompensation einer Gate-Source-Kapazität jedes Zweiges (1, 2),
wobei sich jeweils eine Kapazität des Paares mit der Gate-Source-Kapazität des zugehörigen Zweiges (1, 2) gleicht,
und/oder
zur Kompensation einer Gate-Drain-Kapazität jedes Zweiges (1, 2),
wobei sich jeweils eine Kapazität des Paares mit der Gate-Drain-Kapazität des zugehörigen Zweiges (1, 2) gleicht.

2. Kaskoden-Differenzverstärker, insbesondere nach Anspruch 1,
- mit einem ersten Transistor mit einer ersten Basis, einem ersten Kollektor und einem ersten Emitter, wobei die erste Basis mit einem ersten Eingang verbunden ist,
- mit einem zweiten Transistor mit einer zweiten Basis, einem zweiten Kollektor und einem zweiten Emitter, wobei die zweite Basis mit einem zweiten Eingang verbunden ist,
- mit einem dritten Transistor mit einer dritten Basis, einem dritten Kollektor und einem dritten Emitter, wobei der dritte Emitter des dritten Transistors mit dem ersten Kollektor des ersten Transistors verbunden ist,
- mit einem vierten Transistor mit einer vierten Basis, einem vierten Kollektor und einem vierten Emitter, wobei der vierte Emitter des vierten Transistor mit dem zweiten Kollektor des zweiten Transistor verbunden ist, und
- mit einem ersten Paar von Kapazitäten, wobei eine erste Kapazität des ersten Paares mit der dritten Basis des dritten Transistors und mit dem vierten Emitter des vierten Transistors verbunden ist, und wobei eine zweite Kapazität des ersten Paares mit der vierten Basis des vierten Transistors und mit dem dritten Emitter des dritten Transistors verbunden ist.

3. Kaskoden-Differenzverstärker, insbesondere nach Anspruch 1,
- mit einem ersten Transistor (Q_{N1}) mit einer ersten Basis (B_{N1}), einem ersten Kollektor (K_{N1}) und einem ersten Emitter (E_{N1}), wobei die erste Basis (B_{N1}) mit einem ersten Eingang (IE_{N1}) verbunden ist,
- mit einem zweiten Transistor (Q_{N2}) mit einer zweiten Basis (B_{N2}), einem zweiten Kollektor (K_{N2}) und einem zweiten Emitter (E_{N2}), wobei die zweite Basis (B_{N2}) mit einem zweiten Eingang (IE_{N2}) verbunden ist,
- mit einem dritten Transistor (Q_{N3}) mit einer dritten Basis (B_{N3}), einem dritten Kollektor (K_{N3}) und einem dritten Emitter (E_{N3}), wobei der dritte Emitter (E_{N3}) des dritten Transistors (Q_{N3}) mit dem ersten Kollektor (K_{N1}) des ersten Transistors (Q_{N1}) verbunden ist,
- mit einem vierten Transistor (Q_{N4}) mit einer vierten Basis (B_{N4}), einem vierten Kollektor (K_{P4}, K_{N4}) und einem vierten Emitter (E_{P4}, E_{N4}), wobei der vierte Emitter (E_{N4}) des vierten Transistor (Q_{N4}) mit dem zweiten Kollektor (K_{N2}) des zweiten Transistor (Q_{N2}) verbunden ist, und
- mit einem zweiten Paar von Kapazitäten, wobei eine erste Kapazität des zweiten Paares mit der dritten Basis (B_{N3}) des dritten Transistors (Q_{N3}) und mit dem vierten Kollektor (K_{N4}) des vierten Transistors (Q_{N4}) verbunden ist, und wobei eine zweite Kapazität des zweiten Paares mit der vierten Basis (B_{N4}) des vierten Transistors (Q_{N4}) und mit dem dritten Kollektor (K_{N3}) des dritten Transistors (Q_{N3}) verbunden ist.

4. Kaskoden-Differenzverstärker, insbesondere nach Anspruch 1,
- mit einem ersten Transistor (Q_{P1}, Q_{N1}) mit einer ersten Basis (B_{P1}, B_{N1}), einem ersten Kollektor (K_{P1}, K_{N1}) und einem ersten Emitter (E_{P1}, E_{N1}), wobei die erste Basis (B_{P1}, B_{N1}) mit einem ersten Eingang (IE_{P1}, IE_{N1}) verbunden ist,
- mit einem zweiten Transistor (Q_{P2}, Q_{N2}) mit einer zweiten Basis (B_{P2}, B_{N2}), einem zweiten Kollektor (K_{P2}, K_{N2}) und einem zweiten Emitter (E_{P2}, E_{N2}), wobei die zweite Basis (B_{P2}, B_{N2}) mit einem zweiten Eingang (IE_{P2}, IE_{N2}) verbunden ist,
- mit einem dritten Transistor (Q_{P3}, Q_{N3}) mit einer dritten Basis (B_{P3}, B_{N3}), einem dritten Kollektor (K_{P3}, K_{N3}) und einem dritten Emitter (E_{P3}, E_{N3}), wobei der dritte Emitter (E_{P3}, E_{N3}) des dritten Transistors (Q_{P3}, Q_{N3}) mit dem ersten Kollektor (K_{P1}, K_{N1}) des ersten Transistors (Q_{P1}, Q_{N1}) verbunden ist,
- mit einem vierten Transistor (Q_{P4}, Q_{N4}) mit einer vierten Basis (B_{P4}, B_{N4}), einem vierten Kollektor (K_{P4}, K_{N4}) und einem vierten Emitter (E_{P4}, E_{N4}), wobei der vierte Emitter (E_{P4}, E_{N4}) des vierten Transistor (Q_{P4}, Q_{N4}) mit dem zweiten Kollektor (K_{P2}, K_{N2}) des zweiten Transistor (Q_{P2}, Q_{N2}) verbunden ist, und
- mit einem dritten Paar von Kapazitäten, wobei eine erste Kapazität des dritten Paares mit der ersten Basis (B_{P1}, B_{N1}) des ersten Transistors (Q_{P1}, Q_{N1}) und mit dem zweiten Emitter (E_{P2}, E_{N2}) des zweiten Transistors (Q_{P2}, Q_{N2}) verbunden ist, und wobei eine zweite Kapazität des dritten Paares mit der zweiten Basis (B_{P2}, B_{N2}) des zweiten Transistors (Q_{P2}, Q_{N2}) und mit dem ersten Emitter (E_{P1}, E_{N1}) des ersten Transistors (Q_{P1}, Q_{N1}) verbunden ist.

5. Kaskoden-Differenzverstärker, insbesondere nach Anspruch 1,
- mit einem ersten Transistor (Q_{N1}) mit einer ersten Basis (B_{N1}), einem ersten Kollektor (K_{N1}) und einem ersten Emitter (E_{N1}), wobei die erste Basis (B_{N1}) mit einem ersten Eingang (IE_{N1}) verbunden ist,
- mit einem zweiten Transistor (Q_{N2}) mit einer zweiten Basis (B_{N2}), einem zweiten Kollektor (K_{N2}) und einem zweiten Emitter (E_{N2}), wobei die zweite Basis (B_{N2}) mit einem zweiten Eingang (IE_{N2}) verbunden ist,
- mit einem dritten Transistor (Q_{N3}) mit einer dritten Basis (B_{N3}), einem dritten Kollektor (K_{N3}) und einem dritten Emitter (E_{N3}), wobei der dritte Emitter (E_{N3}) des dritten Transistors (Q_{N3}) mit dem ersten Kollektor (K_{N1}) des ersten Transistors (Q_{N1}) verbunden ist,
- mit einem vierten Transistor (Q_{N4}) mit einer vierten Basis (B_{N4}), einem vierten Kollektor (K_{N4}) und einem vierten Emitter (E_{N4}), wobei der vierte Emitter (E_{N4}) des vierten Transistor (Q_{N4}) mit dem zweiten Kollektor (K_{N2}) des zweiten Transistor (Q_{N2}) verbunden ist, und
- mit einem vierten Paar von Kapazitäten, wobei eine erste Kapazität des vierten Paares mit der ersten Basis (B_{N1}) des ersten Transistors (Q_{N1}) und mit dem zweiten Kollektor (K_{N2}) des zweiten Transistors (Q_{N2}) verbunden ist, und wobei eine zweite Kapazität des vierten Paares mit der zweiten Basis (B_{N2}) des zweiten Transistors (Q_{N2}) und mit dem ersten Kollektor (Kp₁, K_{N1}) des ersten Transistors (Q_{P1}, Q_{N1}) verbunden ist.

6. Kaskoden-Differenzverstärker nach zumindest zwei der Ansprüche 2 bis 5, der zumindest zwei Paare von Kapazitäten aus dem ersten Paar von Kapazitäten, dem zweiten Paar von Kapazitäten, dem dritten Paar von Kapazitäten oder dem vierten Paar von Kapazitäten aufweist.

7. Kaskoden-Differenzverstärker nach einem der vorhergehenden Ansprüche, bei dem zumindest eine Kapazität der Paare von Kapazitäten durch eine Basis-Emitter-Kapazität oder eine Basis-Kollektor-Kapazität eines Transistors (Q_{P5}, Q_{P6}, Q_{N5} bis Q_{N10}) gebildet ist.

8. Kaskoden-Differenzverstärker zumindest nach Anspruch 5, bei dem das vierte Paar von Kapazitäten durch eine Basis-Kollektor-Kapazität eines fünften Transistors (Q_{N5}) und durch eine Basis-Kollektor-Kapazität eines einen sechsten Transistor (Q_{N6}) gebildet ist,
- mit dem fünften Transistor (Q_{N5}) mit einer fünften Basis (B_{N5}), einem fünften Kollektor (K_{N5}) und einem fünften Emitter (E_{N5}), wobei die fünfte Basis (B_{N5}) des fünften Transistors (Q_{N5}) mit der ersten Basis (B_{N1}) des ersten Transistors (Q_{N1}) verbunden ist, wobei der fünfte Kollektor (K_{N5}) des fünften Transistors (Q_{N5}) mit dem zweiten Kollektor (K_{N2}) des zweiten Transistors (Q_{N2}) verbunden ist, und
- mit dem sechsten Transistor (Q_{N6}) mit einer sechsten Basis (B_{N6}), einem sechsten Kollektor (K_{N6}) und einem sechsten Emitter (E_{N6}),
wobei die sechste Basis (B_{N6}) des sechsten Transistors (Q_{N6}) mit der zweiten Basis (B_{N2}) des zweiten Transistors (Q_{N2}) verbunden ist, wobei der sechste Kollektor (K_{N6}) des sechsten Transistors (Q_{N6}) mit dem ersten Kollektor (K_{N1}) des ersten Transistors (Q_{N1}) verbunden ist.

9. Kaskoden-Differenzverstärker zumindest nach Anspruch 4, bei dem das dritte Paar von Kapazitäten durch eine Basis-Emitter-Kapazität eines siebten Transistors (Q_{N7}) und durch eine Basis-Emitter-Kapazität eines achten Transistors (Q_{N8}) gebildet ist,
- mit dem siebten Transistor (Q_{N7}) mit einer siebten Basis (B_{N7}), einem siebten Kollektor (K_{N7}) und einem siebten Emitter (E_{N7}), wobei die siebte Basis (B_{N7}) des siebten Transistors (Q_{N7}) mit der ersten Basis (B_{N1}) des ersten Transistors (Q_{N1}) verbunden ist, wobei der siebte Emitter (E_{N7}) des siebten Transistors (Q_{N7}) mit dem zweiten Emitter (E_{N2}) des zweiten Transistors (Q_{N2}) verbunden ist, und
- mit dem achten Transistor (Q_{N8}) mit einer achten Basis (B_{N8}), einem achten Kollektor (K_{N8}) und einem achten Emitter (E_{N8}), wobei die achte Basis (B_{N8}) des achten Transistors (Q_{N8}) mit der zweiten Basis (B_{N2}) des zweiten Transistors (Q_{N2}) verbunden ist, wobei der achte Emitter (E_{N8}) des achten Transistors (Q_{N8}) mit dem ersten Emitter (E_{N1}) des ersten Transistors (Q_{N1}) verbunden ist.

10. Kaskoden-Differenzverstärker zumindest nach Anspruch 3, bei dem das zweite Paar von Kapazitäten durch eine Basis-Kollektor-Kapazität eines neunten Transistors (Q_{N9}) und durch eine Basis-Kollektor-Kapazität eines zehnten Transistors (Q_{N10}) gebildet ist,
- mit dem neunten Transistor (Q_{N9}) mit einer neunten Basis (B_{N9}), einem neunten Kollektor (K_{N9}) und einem neunten Emitter (E_{N9}), und
- mit dem zehnten Transistor (Q_{N10}) mit einer zehnten Basis (B_{N10}), einem zehnten Kollektor (K_{N10}) und einem zehnten Emitter (E_{N10}),
wobei
- die neunte Basis (B_{N9}) des neunten Transistors (Q_{N9}) mit der dritten Basis (B_{N3}) des dritten Transistors (Q_{N3}) verbunden ist,
- der neunte Kollektor (K_{N9}) des neunten Transistors (Q_{N9}) mit dem vierten Kollektor (K_{N4}) des vierten Transistors (Q_{N4}) verbunden ist,
- die zehnte Basis (B_{N10}) des zehnten Transistors (Q_{N10}) mit der vierten Basis (B_{N4}) des vierten Transistors (Q_{N4}) verbunden ist, und
- der zehnte Kollektor (K_{N10}) des zehnten Transistors (Q_{N10}) mit dem dritten Kollektor (K_{N3}) des dritten Transistors (Q_{N3}) verbunden ist.

11. Kaskoden-Differenzverstärker zumindest nach Anspruch 2, bei dem das erste Paar von Kapazitäten durch eine Basis-Emitter-Kapazität eines elften Transistors und durch eine Basis-Emitter-Kapazität eines zwölften Transistors gebildet ist,
- mit dem elften Transistor mit einer elften Basis, einem elften Kollektor und einem elften Emitter, und
- mit dem zwölften Transistor mit einer zwölften Basis, einem zwölften Kollektor und einem zwölften Emitter,
wobei
- die elfte Basis des elften Transistors mit der dritten Basis des dritten Transistors verbunden ist,
- der elfte Emitter des elften Transistors mit dem vierten Emitter des vierten Transistors verbunden ist,
- die zwölfte Basis des zwölften Transistors mit der vierten Basis des vierten Transistors verbunden ist, und
- der zwölfte Emitter des zwölften Transistors mit dem dritten Emitter des dritten Transistors verbunden ist.

12. Kaskoden-Differenzverstärker nach einem der vorhergehenden Ansprüche mit zumindest einem Anpassnetzwerk (X_{N1}, X_{N2}) das mit zumindest einem Transistor (Q_{N1} .Q_{N6}) verbunden ist.

13. Kaskoden-Differenzverstärker nach einem der vorhergehenden Ansprüche, bei dem anstelle von Bipolartransistoren (Q_{N1} ..Q_{N10}, Q_{P1} ... Q_{P6}) zumindest teilweise Feldeffekttransistoren mit jeweils einem Tor anstelle einer Basis (B_{N1} ..B_{N10}, B_{P1} ..B_{P6}), einer Senke anstelle eines Kollektors (K_{N1} .KN₁₀, K_{P1} .K_{P6}) und einer Quelle anstelle eines Emitters (E_{N1} .E_{N10}, E_{P1} .E_{P6}) verbunden sind.

## Geänderte Patentansprüche

### Geänderte Patentansprüche gemäss Regel 86(2) EPÜ.

**1.** Kaskoden-Differenzverstärker
- mit einem ersten Transistor (Q_{P1}, Q_{N1}) mit einer ersten Basis (B_{P1}, B_{N1}), einem ersten Kollektor (K_{P1}, K_{N1}) und einem ersten Emitter (E_{P1}, E_{N1}), wobei die erste Basis (B_{P1}, B_{N1}) mit einem ersten Eingang (IE_{P1}, IE_{N1}) verbunden ist,
- mit einem zweiten Transistor (Q_{P2}, Q_{N2}) mit einer zweiten Basis (B_{P2}, B_{N2}), einem zweiten Kollektor (K_{P2}, K_{N2}) und einem zweiten Emitter (E_{P2}, E_{N2}), wobei die zweite Basis (B_{P2}, B_{N2}) mit einem zweiten Eingang (IE_{P2}, IE_{N2}) verbunden ist,
- mit einem dritten Transistor (Q_{P3}, Q_{N3}) mit einer dritten Basis (B_{P3}, B_{N3}), einem dritten Kollektor (K_{P3}, K_{N3}) und einem dritten Emitter (E_{P3}, E_{N3}), wobei der dritte Emitter (E_{P3}, E_{N3}) des dritten Transistors (Q_{P3}, Q_{N3}) mit dem ersten Kollektor (K_{P1}, K_{N1}) des ersten Transistors (Q_{P1}, Q_{N1}) verbunden ist,
- mit einem vierten Transistor (Q_{P4}, Q_{N4}) mit einer vierten Basis (B_{P4}, B_{N4}), einem vierten Kollektor (K_{P4}, K_{N4}) und einem vierten Emitter (E_{P4}, E_{N4}), wobei der vierte Emitter (E_{P4}, E_{N4}) des vierten Transistor (Q_{P4}, Q_{N4}) mit dem zweiten Kollektor (K_{P2}, K_{N2}) des zweiten Transistor (Q_{P2}, Q_{N2}) verbunden ist, und
- mit einem Paar von Kapazitäten, wobei eine erste Kapazität des Paares mit der ersten Basis (B_{N1}) des ersten Transistors (Q_{N1}) und mit dem zweiten Kollektor (K_{N2}) des zweiten Transistors (Q_{N2}) verbunden ist, und wobei eine zweite Kapazität des Paares mit der zweiten Basis (B_{N2}) des zweiten Transistors (Q_{N2}) und mit dem ersten Kollektor (K_{P1}, K_{N1}) des ersten Transistors (Q_{P1}, Q_{N1}) verbunden ist.

**2.** Kaskoden-Differenzverstärker nach Anspruch1,
mit einem weiteren Paar von Kapazitäten, wobei eine erste Kapazität des weiteren Paares mit der ersten Basis (B_{P1}, B_{N1}) des ersten Transistors (Q_{P1}, Q_{N1}) und mit dem zweiten Emitter (E_{P2}, E_{N2}) des zweiten Transistors (Q_{P2}, Q_{N2}) verbunden ist, und wobei eine zweite Kapazität des weiteren Paares mit der zweiten Basis (B_{P2}, B_{N2}) des zweiten Transistors (Q_{P2}, Q_{N2}) und mit dem ersten Emitter (E_{P1}, E_{N1}) des ersten Transistors (Q_{P1}, Q_{N1}) verbunden ist.

**3.** Kaskoden-Differenzverstärker nach einem der vorhergehenden Ansprüche, bei dem zumindest eine Kapazität der Paare von Kapazitäten durch eine Basis-Emitter-Kapazität oder eine Basis-Kollektor-Kapazität eines Transistors (Q_{P5}, Q_{P6}, Q_{N5} bis Q_{N10}) gebildet ist.

**4.** Kaskoden-Differenzverstärker nach einem der vorhergehenden Ansprüche, bei dem das Paar von Kapazitäten durch eine Basis-Kollektor-Kapazität eines fünften Transistors (Q_{N5}) und durch eine Basis-Kollektor-Kapazität eines einen sechsten Transistor (Q_{N6}) gebildet ist,
- mit dem fünften Transistor (Q_{N5}) mit einer fünften Basis (B_{N5}), einem fünften Kollektor (K_{N5}) und einem fünften Emitter (E_{N5}), wobei die fünfte Basis (B_{N5}) des fünften Transistors (Q_{N5}) mit der ersten Basis (B_{N1}) des ersten Transistors (Q_{N1}) verbunden ist, wobei der fünfte Kollektor (K_{N5}) des fünften Transistors (Q_{N5}) mit dem zweiten Kollektor (K_{N2}) des zweiten Transistors (Q_{N2}) verbunden ist, und
- mit dem sechsten Transistor (Q_{N6}) mit einer sechsten Basis (B_{N6}), einem sechsten Kollektor (K_{N6}) und einem sechsten Emitter (E_{N6}),
wobei die sechste Basis (B_{N6}) des sechsten Transistors (Q_{N6}) mit der zweiten Basis (B_{N2}) des zweiten Transistors (Q_{N2}) verbunden ist,
wobei der sechste Kollektor (K_{N6}) des sechsten Transistors (Q_{N6}) mit dem ersten Kollektor (K_{N1}) des ersten Transistors (Q_{N1}) verbunden ist.

**5.** Kaskoden-Differenzverstärker zumindest nach Anspruch 2, bei dem das weitere Paar von Kapazitäten durch eine Basis-Emitter-Kapazität eines siebten Transistors (Q_{N7}) und durch eine Basis-Emitter-Kapazität eines achten Transistors (Q_{N8}) gebildet ist,
- mit dem siebten Transistor (Q_{N7}) mit einer siebten Basis (B_{N7}), einem siebten Kollektor (K_{N7}) und einem siebten Emitter (E_{N7}), wobei die siebte Basis (B_{N7}) des siebten Transistors (Q_{N7}) mit der ersten Basis (B_{N1}) des ersten Transistors (Q_{N1}) verbunden ist, wobei der siebte Emitter (E_{N7}) des siebten Transistors (Q_{N7}) mit dem zweiten Emitter (E_{N2}) des zweiten Transistors (Q_{N2}) verbunden ist, und
- mit dem achten Transistor (Q_{N8}) mit einer achten Basis (B_{N8}), einem achten Kollektor (K_{N8}) und einem achten Emitter (E_{N8}), wobei die achte Basis (B_{N8}) des achten Transistors (Q_{N8}) mit der zweiten Basis (B_{N2}) des zweiten Transistors (Q_{N2}) verbunden ist, wobei der achte Emitter (E_{N8}) des achten Transistors (Q_{N8}) mit dem ersten Emitter (E_{N1}) des ersten Transistors (Q_{N1}) verbunden ist.

**6.** Kaskoden-Differenzverstärker nach einem der vorhergehenden Ansprüche mit zumindest einem Anpassnetzwerk (X_{N1}, X_{N2}) das mit zumindest einem Transistor (Q_{N1} ... Q_{N6}) verbunden ist.

**7.** Kaskoden-Differenzverstärker nach einem der vorhergehenden Ansprüche, bei dem anstelle von Bipolartransistoren (Q_{N1} ... Q_{N10,} Q_{P1} ... Q_{P6}) zumindest teilweise Feldeffekttransistoren mit jeweils einem Tor anstelle einer Basis (B_{N1} ... B_{N10}, B_{P1} ... B_{P6}), einer Senke anstelle eines Kollektors (K_{N1} ... K_{N10}, K_{P1} ... K_{P6}) und einer Quelle anstelle eines Emitters (E_{N1} ... E_{N10}, E_{P1} ... E_{P6}) verbunden sind.

**8.** Kaskoden-Differenzverstärker
- mit einem ersten Transistor (Q_{P1}, Q_{N1}) mit einer ersten Basis (B_{P1}, B_{N1}), einem ersten Kollektor (K_{P1}, K_{N1}) und einem ersten Emitter (E_{P1}, E_{N1}), wobei die erste Basis (B_{P1}, B_{N1}) mit einem ersten Eingang (IE_{P1}, IE_{N1}) verbunden ist,
- mit einem zweiten Transistor (Q_{P2}, Q_{N2}) mit einer zweiten Basis (B_{P2}, B_{N2}), einem zweiten Kollektor (K_{P2}, K_{N2}) und einem zweiten Emitter (E_{P2}, E_{N2}), wobei die zweite Basis (B_{P2}, B_{N2}) mit einem zweiten Eingang (IE_{P2}, IE_{N2}) verbunden ist,
- mit einem dritten Transistor (Q_{P3}, Q_{N3}) mit einer dritten Basis (B_{P3}, B_{N3}), einem dritten Kollektor (K_{P3}, K_{N3}) und einem dritten Emitter (E_{P3}, E_{N3}), wobei der dritte Emitter (E_{P3}, E_{N3}) des dritten Transistors (Q_{P3}, Q_{N3}) mit dem ersten Kollektor (K_{P1}, K_{N1}) des ersten Transistors (Q_{P1}, Q_{N1}) verbunden ist,
- mit einem vierten Transistor (Q_{P4}, Q_{N4}) mit einer vierten Basis (B_{P4}, B_{N4}), einem vierten Kollektor (K_{P4}, K_{N4}) und einem vierten Emitter (E_{P4}, E_{N4}), wobei der vierte Emitter (E_{P4}, E_{N4}) des vierten Transistor (Q_{P4}, Q_{N4}) mit dem zweiten Kollektor (K_{P2}, K_{N2}) des zweiten Transistor (Q_{P2}, Q_{N2}) verbunden ist, und
- mit einer ersten Kapazität und einer zweiten Kapazität, wobei die erste Kapazität mit der ersten Basis (B_{P1}, B_{N1}) des ersten Transistors . (Q_{P1}, Q_{N1}) und mit dem zweiten Emitter (E_{P2}, E_{N2}) des zweiten Transistors (Q_{P2}, Q_{N2}) verbunden ist, und wobei die zweite Kapazität mit der zweiten Basis (B_{P2}, B_{N2}) des zweiten Transistors (Q_{P2}, Q_{N2}) und mit dem ersten Emitter (E_{P1}, E_{N1}) des ersten Transistors (Q_{P1}, Q_{N1}) verbunden ist.
